# EUROPEAN PATENT APPLICATION

(11) **EP 4 213 320 A1**
(43) Date of publication of application: **19.07.2023**
(21) Application number: 22217329.6
(22) Date of filing: 30.12.2022
(51) Int. Cl.: H02B 1/44, E05D 1/02, H02G 3/14

(54) **AN ELECTRICAL MOUNTING ENCLOSURE**

(30) Priority: 14.01.2022 FI 20225030
(71) Applicant: Katko Oy, 00390 Helsinki (FI)
(72) Inventor: Kariniemi, Reijo, 00390 Helsinki (FI); Hyryläinen, Markus, 00390 Helsinki (FI)
(74) Representative: Primrose Oy

(57) **Abstract**

The invention relates to an electrical mounting enclosure (1) for surface-mounted electrical installation comprising a housing (2) and a lid (3) connectable to the housing (2) and arranged to close the opening (23) of the housing (2) for providing a closed electrical mounting enclosure (1) having an interior space (10). The electrical mounting enclosure (1) comprises a primary through hole (4) arranged to the housing (2), a secondary through hole (5) arranged to the lid (3), the primary through hole (4) of the housing (2) and the secondary through hole (5) of the lid (3) are adapted to receive a same elongate connecting portion (6) so that the elongate connecting portion (6) passes through the primary through hole (4) and the secondary through hole (5) to connect the housing (2) and the lid (3) to each other through the connecting portion (6).

## Description

### FIELD OF THE INVENTION

The present invention relates to an electrical mounting enclosure and more particularly to an electrical mounting enclosure as defined by the preamble of the independent claim 1.

### BACKGROUND OF THE INVENTION

In the prior art electrical mounting enclosures which are used in electrical installations, the electrical mounting enclosures typically comprise a housing and a lid which are two separate pieces, and which are connected together through screws when the electrical installation is completed. The electrical installation is provided within the housing and the housing is connected to a mounting surface which is typically a wall or similar structure. The lid is the last piece which is connected to the electrical mounting enclosure when the electrical installation is completed. It protects the electrical components provided inside the electrical mounting enclosure.

Another type of prior art electrical mounting enclosure comprises a hinge connecting the housing and the lid together. The lid can be opened to allow electrical installation work inside the housing of the electrical mounting enclosure. The hinge allows the lid to open next to the housing at most the same level as the housing opening.

One of the problems associated with the prior art is that when the electrician works in an installation place the lid is either a separate piece placed somewhere waiting to be used for closing the electrical mounting enclosure and it can be lost, or the lid is connected to the housing through a hinge and remains safe without being lost but is in the way of installation when it is at maximum parallel to the opening of the housing on the side of the housing. The hinge structure is normally made of plastic, and it is also rigid such that the lid tries to move back towards the opening of the housing thereby disrupting the installation work.

### BRIEF DESCRIPTION OF THE INVENTION

An object of the present invention is to provide an electrical mounting enclosure which alleviates the problems of the prior art.

The objects of the invention are achieved by an electrical mounting enclosure which is characterized by what is stated in the independent claim. The preferred embodiments of the invention are disclosed in the dependent claims.

The invention is based on the idea of providing an electrical mounting enclosure which allows easy installation by the installer so that all the enclosure parts can be held in one hand during installation while the other hand is used for mounting the enclosure to the mounting surface.

An electrical mounting enclosure according to the invention for surface-mounted electrical installation comprising a housing having a housing bottom and housing walls. Said housing walls protruding from the housing bottom and forming an opening to the housing. The electrical mounting enclosure further comprising a lid connectable to the housing and arranged to close the opening of the housing for providing a closed electrical mounting enclosure having an interior space. The electrical mounting enclosure comprises a primary through hole arranged to the housing. The primary through hole having an inlet opening and an outlet opening such that the primary through hole extending between the inlet opening and the outlet opening. In other words, the primary through hole has a primary inlet opening and a primary outlet opening. The electrical mounting enclosure also comprises a secondary through hole arranged to the lid. The secondary through hole having an inlet opening and an outlet opening such that the secondary through hole extending between the inlet opening and the outlet opening. In other words, the secondary through hole has a secondary inlet opening and a secondary outlet opening. The primary through hole of the housing and the secondary through hole of the lid are adapted to receive a same elongate connecting portion so that the elongate connecting portion passes through the primary through hole and the secondary through hole to connect the housing and the lid to each other through the connecting portion.

The electrical mounting enclosure according to the invention having the primary through hole in connection with the housing and the secondary through hole in connection with the lid provides a way to connect the housing and the lid together through an elongate connecting portion. This elongate connecting portion may be one that the installer has in the toolbox, for example a cable tie, or alternatively the elongate connecting portion may already be part of the electrical mounting enclosure.

According to the invention the primary through hole of the housing and the secondary through hole of the lid are arranged such that the primary through hole and the secondary through hole are parallel in the closed electrical mounting enclosure. The primary through hole and the secondary through hole are preferably provided such that the inlet openings of the through holes and the outlet openings of the through holes open into the interior space of the closed electrical mounting enclosure and are connectable together through an elongate connecting portion.

According to the invention the primary through hole of the housing and the secondary through hole of the lid are arranged such that the through holes are arranged overlapping or at least partially overlapping in a height direction of the closed electrical mounting enclosure. In other words, the overlapping or at least partly overlapping through holes are provided on top of each other at least partly such that a path through the primary through hole and the secondary through hole is formed. The height direction of closed electrical mounting enclosure is the perpendicular direction extending between the housing bottom and the lid.

According to the invention the primary through hole of the housing and the secondary through hole of the lid are arranged such that the through holes are arranged in the same line in the height direction of the closed electrical mounting enclosure such that a path through the holes is formed.

According to the invention the primary through hole of the housing and the secondary through hole of the lid are arranged such that the through holes are coaxial in the closed electrical mounting enclosure. Further the primary through hole and the secondary through hole are coaxial inside the electrical mounting enclosure such that the inlet openings of the through holes and the outlet openings of the through holes open into the interior space of the closed electrical mounting enclosure. Alternatively, the openings of the housing and the lid, which are opposite to each other, can be arranged so as to be aligned so that the through holes of the housing and the lid form a single integral through hole in the closed electrical mounting enclosure.

According to the invention the primary through hole is formed by a structure arranged in connection with one of the housings walls such that the inlet opening and the outlet opening of the primary through hole open into the interior space formed inside the closed electrical mounting enclosure. The structure for the primary through hole is thus arranged to form the through hole as well as the inlet and the outlet of the through hole. The structure forming the primary through hole is connected the housing wall.

According to the invention the primary through hole is at least partly formed by one of the housing walls. In a preferred embodiment of the invention, the housing wall forms part of the structure forming the through hole. In other words, the structure forming the primary through hole comprises a connection to the housing wall such that part of the primary through hole is formed by the housing wall and the rest is formed by the structure connected to the housing wall.

According to the invention the secondary through hole is formed by a structure arranged in connection with the lid such that the inlet opening and the outlet opening of the secondary through hole open into the interior space formed inside the closed electrical mounting enclosure. In other words, the structure forming the secondary through hole is connected to the lid such that the secondary through hole extends within the closed electrical mounting enclosure.

According to the invention the secondary through hole is at least partly formed by the lid. In a preferred embodiment of the invention, the lid forms part of the structure forming the through hole. In other words, the structure forming the secondary through hole comprises a connection to the lid such that part of the primary through hole is formed by the lid and the rest is formed by the structure connected to the lid.

According to the invention the electrical mounting enclosure further comprises an elongate connecting portion arranged to connect the housing and the lid together through the primary through hole and the secondary through hole. The elongate connecting portion being arranged in connection with the housing and the lid such that an angle of movement of the lid from an open state of the electrical mounting enclosure to the closed electrical mounting enclosure is at least 180°.

In a preferred embodiment of the invention the angle of movement of the lid between the open state of the electrical mounting enclosure and the closed electrical mounting enclosure is more than 180°. The lid preferably opens relative to the housing such that the elongate connecting portion allows the lid to be placed on the side of the housing, thereby the angle of movement of the lid can be even 270° when the placement of the electrical mounting enclosure so allows.

According to the invention the elongate connecting portion being adjustable in length such that the angle of movement of the lid relative to the housing is changeable.

The elongate connecting portion being adjustable in length means that when the electrician works with the electrical mounting enclosure the lid needs to be away from the vicinity of the opening to the housing and thereby the elongate connection portion may have the length such that the lid is further away from the housing, and when the lid is connected to the housing the elongate connecting portion may be adjusted shorter so that the elongate connecting portion does not disrupt the electrical connections within the electrical mounting enclosure. The elongate connecting portion can also be locked to a certain length in addition to being adjustable in length.

According to the invention the elongate connecting portion is flexible such that the elongate connecting portion is particularly flexible in the longitudinal direction.

In the closed electrical mounting enclosure according to the invention, the lid is against the housing, closing the opening to the housing. In an open state of the electrical mounting enclosure the lid is connected to the housing only through the elongate connecting portion. There can be only one elongate connecting portion or multiple elongate connecting portions, but the only fixed connection between the housing and the lid is through the elongate connecting portion. Thereby, the position and place of the lid relative to the housing is changeable according to the length of the elongate connecting portion and within the limits allowed by the elongate connecting portion. This allows movement of the lid to be more than around an imaginary axis thus also in other directions. In an open state of the electrical mounting enclosure the position and distance of the lid relative to the housing is therefore changeable within the limits allowed by the elongate connecting portion.

According to the invention the housing bottom facing toward the interior space comprises at least two connectors arranged to connect a mounting rail or a mounting plate to the housing bottom. The at least two connectors are arranged to protrude from the housing bottom toward the interior space and comprise a structure to which the mounting rail or the mounting plate for electrical components is attached.

According to the invention the connectors are arranged such that the mounting rail extends in a length direction of the housing bottom or in a width direction of the housing bottom. The connectors protruding from the housing bottom are preferably arranged closer to the housing walls than the midpoint of the housing bottom.

According to the invention the electrical mounting enclosure comprises connecting holes for connecting the electrical mounting enclosure to a mounting surface with screws, which the connecting holes are arranged outside the interior space of the housing such that the connecting holes extend through the housing in a height direction of the housing. The connecting holes are preferably provided to the housing walls and in particular at the corners of the housing walls.

According to the invention the housing bottom comprises hole blanks for an alternative way of connecting the electrical mounting enclosure to a mounting surface. The hole blanks are provided at the housing bottom, but they are not through holes through the housing bottom. The hole blanks are structure which can be easily broken at the housing bottom in order to provide holes through the housing bottom such that the electrical mounting enclosure can be connected to the mounting surface with screws of other connectors through the holes.

According to the invention the housing comprises corners, and the lid comprises corresponding corners, which abut against the corners of the housing in the closed electrical mounting enclosure. The corners of the housing and lid having a closing mechanism for securing the closed electrical mounting enclosure. The corners of the lid thereby connect to the corners of the housing in the closed electrical mounting enclosure. The closing mechanism may be for example a screw mechanism or click-to-connect closing mechanism.

According to the invention the electrical mounting enclosure further comprising a sealing provided between the housing and the lid in the closed electrical mounting enclosure for providing a tight electrical mounting enclosure. The electrical mounting enclosure may be water-tight and/or dust-tight because of the sealing.

According to the invention the sealing is arranged in connection with the lid. Alternatively, or in addition the sealing is arranged in connection with the housing. Alternatively, or in addition the sealing is part of the lid. Alternatively, or in addition the sealing is part of the housing. The sealing is preferably provided in a groove or recess which can be either in the housing such that the sealing surrounds at least partly the opening to the housing or in the lid positioned such that the part of the lid which touches the housing walls surrounding the opening to the housing when the electrical mounting enclosure is closed, comprise the seal. The sealing is preferably provided to the electrical mounting enclosure such that the sealing surrounds the interior space of the electrical mounting enclosure for providing a water-tight and/or dust-tight interior space of the electrical mounting enclosure. The sealing is preferably provided between the interior space and the connecting holes for separating the interior space and the connecting holes from each other.

An advantage of the invention is that the lid and the housing can be connected together without losing the lid during installation of the electrical mounting enclosure to the mounting surface and during the installation of the electrical components to the housing. Another advantage of the invention is that the lid can be fastened to the housing by means of the elongate connecting portion so that the opening angle of the lid with respect to the housing is large, so that the cover is not disrupting the installation. In addition, the elongate connecting portion is adjustable so that the lid is close to the housing when all components are inside the housing and no further installation work is required.

### BRIEF DESCRIPTION OF THE DRAWINGS

The invention is described in detail by means of specific embodiments with reference to the enclosed drawings, in which
Figure 1a shows an electrical mounting enclosure according to the invention in a closed state;
Figure 1b shows an electrical mounting enclosure according to the invention in an open state;
Figure 2 shows an electrical mounting enclosure according to the invention as seen from above in an open state; and
Figure 3 shown an electrical mounting enclosure according to the invention as seen from side in an open state.

### DETAILED DESCRIPTION OF THE INVENTION

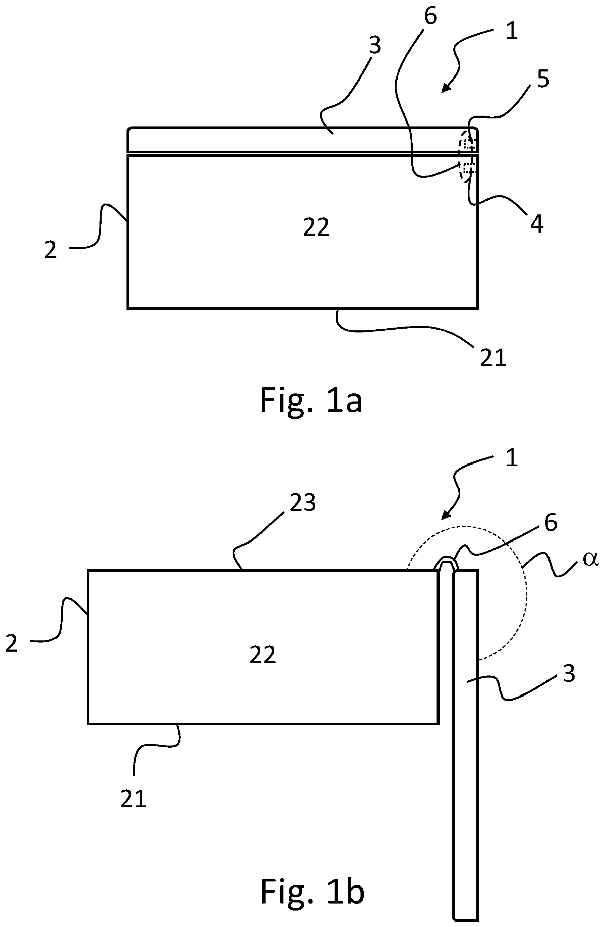

Figure 1a shows an electrical mounting enclosure 1 according to the invention in a closed state and seen from side. The electrical mounting enclosure 1 comprises a housing 2 and a lid 3 closing an opening 23 to the housing 2. The housing 2 having a housing bottom 21 and housing walls 22 protruding from the housing bottom 21. The opening 23 to the housing 2 is formed by the housing walls 22. The electrical mounting enclosure 1 according to the invention comprises a primary through hole 4 arranged to the housing 2 and a secondary through hole 5 arranged to the lid 3. The primary through hole 4 and the secondary through hole 5 have an inlet opening 41, 51 and an outlet opening 42, 52 and the through hole 4, 5 form a passage between the inlet opening 41, 51 and the outlet opening 42, 52. The primary through hole 4 and the secondary through hole 5 are formed in a structure protruding from the housing wall 22 toward the interior space 10 of the housing 2. Thereby the primary through hole 4 and the secondary through hole 5 are formed by a structure protruding from an inner surface of a housing wall 22. The primary through hole 4 of the housing 2 and the secondary through hole 5 of the lid 3 are adapted to receive a same elongate connecting portion 6 so that the elongate connecting portion 6 passes through the primary through hole 4 and the secondary through hole 5 to connect the housing 2 and the lid 3 to each other through the connecting portion 6. The connecting portion 6 is shown as a dashed line in the figure 1a.

The elongate connecting portion 6 may extend between the housing 2 and the lid 3 such that one end of the elongate connecting portion 6 is on that side of the primary through hole 4 which is furthest away from the secondary through hole 5, and the other end of the elongate connecting portion 6 is on that side of the secondary through hole 5 which is the furthest away from the primary through hole 4, and the elongate connecting portion 6 passing through the primary through hole 4 and the secondary through hole 5. The ends of the elongate connection portion 6 having a section which does not pass through the through holes 4, 5 holding the elongate connection portion 6 in place extending between the housing 2 and the lid 3 and tying the housing 2 and the lid 3 together. Alternatively, the elongate connection portion 6 forming a loop such that the loop ties the housing 2 and the lid 3 together when passing through the primary through hole 4 and the secondary through hole 5.

Figure 1b shows an electrical mounting enclosure 1 according to the invention in an open state such that the lid 3 is removed from the contact with the housing 2. The electrical mounting enclosure 1 is opened such that the angle α of movement of the lid 3 is more than 180° and in this example it is preferably 270°. The maximum angle α of movement of the lid 3 relative to the opening 23 of the housing 2 is preferably more than 180° and advantageously 270°, er even more than 270°. The elongate connecting portion 6 is preferably adjustable in length so that it is at its longest when the lid 3 is arranged in the most open state, i.e., the angle α of movement is for example 270° and then the elongate connecting portion 6 can be shortened when the installation work inside the electrical mounting enclosure 1 is completed. In the shortest version of the elongate connecting portion 6, the lid 3 can still be opened, but it is not necessary to open it so that the lid is completely out of the way, so that the opening angle can be, for example, 90°. Because of the adjustable elongate connecting portion 6 the lid 3 can be moved from the opening 23 to the housing 2 to next of the housing wall 22 and still be connected to the housing 2.

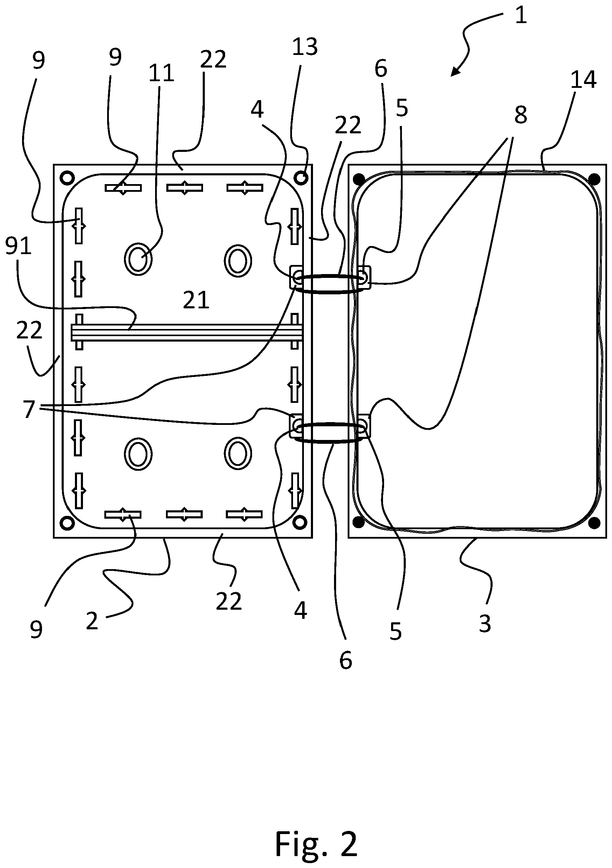

Figure 2 shows an electrical mounting enclosure 1 according to the invention as seen from above in an open state. On the left-hand side is the housing 2 having housing walls 22 protruding from the housing bottom 21. The housing walls 22 together with the housing bottom 21 form the interior space 10 inside the housing 2. The housing bottom 21 comprises hole blanks 11 which can be broken if necessary and when needed in order to provide screws or other connectors through the formed holes for connecting the electrical mounting enclosure 1 to a mounting surface, such as a wall. The housing bottom 21 further comprises connectors 9 for connecting a mounting rail 91 to the housing bottom 21. The mounting rail 91 is provided to the electrical mounting enclosure 1 for arranging electrical components inside the electrical mounting enclosure 1. The mounting rail 91 preferably is arranged such that they extend in a length direction of the housing bottom 21 or in a width direction of the housing bottom 21. In figure 2 the mounting rail 91 connected to opposing connectors 9 is extending the width direction of the housing bottom 21. The connectors 9 are preferably arranged in a vicinity of the housing walls so that the mounting rail 91 is connected to the connectors 9 in the region of the ends of the mounting rails 91. Instead of the mounting rail 91 a mounting plate can be used to cover at least part of the housing bottom 21 to connect electrical components to the housing bottom 21.

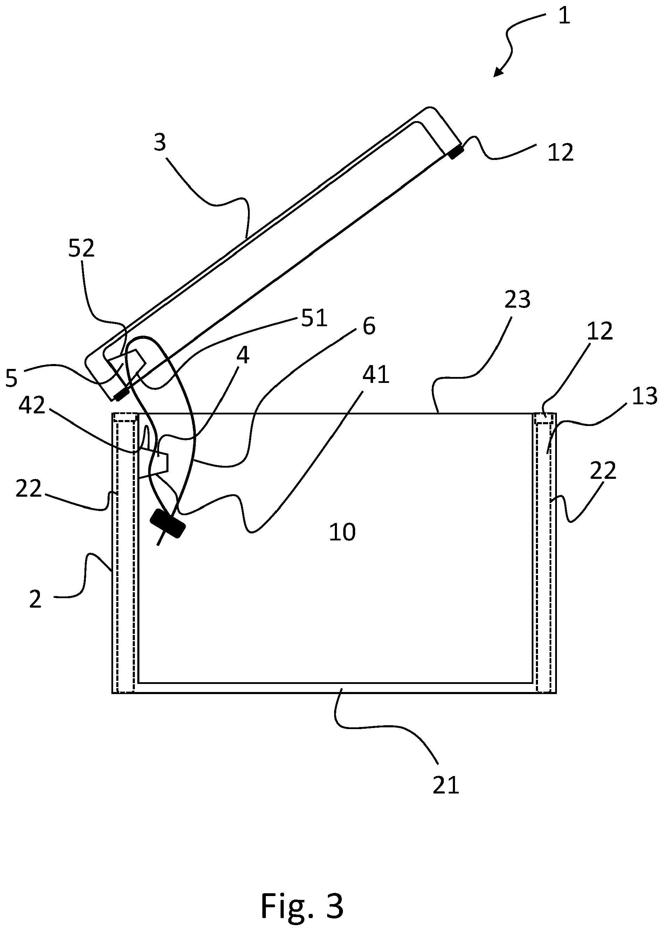

The corners of the housing 2 and the corners of the lid 3 have a closing mechanism 12 for securing the closed electrical mounting enclosure 1. The closing mechanism is provided in this embodiment of the invention shown in figure 3 as recesses in the corners of the housing 2 and protrusions in the corners of the lid 3. However, the closing mechanism 12 may also be a screw connector extending from the lid 3 to a recess in the housing 2. The corners of the housing 2 also comprise connecting holes 13 for screws for connecting the housing 2 to a mounting surface. The connecting holes 13 are arranged outside the interior space 10 of the housing 2 such that the connecting holes 13 extend through the housing 2 in a height direction of the housing 2. The protrusion of the securing mechanism can be inserted into a recess formed by the connecting hole. The housing 2 further comprises a primary through hole 4 and in this embodiment shown in figure 2 there are two primary through holes 4. The primary through holes 4 are provided by a structure 7 protruding from the housing wall 22 such that the housing wall 22 forms part of the structure forming the primary through hole 4. The structure forming the primary through hole 4 extends from the housing wall 22 towards interior space 10 of the housing 2 such that the inlet opening 41 and the outlet opening 42 of the primary through hole 4 open to the interior space 10 of the housing 2. This is shown in more detail in figure 3. The lid 3 is shown on the righthand side in the figure 2 showing the inner surface of the lid 3 facing toward the housing bottom 21 when the electrical mounting enclosure 1 is closed. The embodiment shown in figure 3 shows two secondary through holes 5 which are formed by a structure 8 protruding from an inner side surface of the lid 3. The lid 3 in other words has a recessed portion surrounded by a side structure forming the sides of the lid 3. The sides of the lid 3 have a sealing 14 which presses against the housing walls 22 when the electrical mounting enclosure 1 is closed, forming the housing 2 into a water and/or dust seal. The housing 2 and the lid 3 are connected together through an elongate connecting portion 6 which is formed as a loop. The recessed portion of the lid 3 forms part of the interior space 10 of the closed electrical mounting enclosure 1.

Figure 3 shown an electrical mounting enclosure 1 according to the invention as seen from side as a cut out view in an open state. In this figure, the recessed portion of the lid 3 is shown in more detail, and when the lid 3 is placed in connection with the housing 2 closing the opening 23 of the housing 2 in the closed state of the electrical mounting enclosure 1, the recessed portion of the lid 3 forms part of the interior space 10 of the electrical mounting enclosure 1. For the sake of clarity, the figure 3 does not show the connectors 9 protruding from the housing bottom 21. The closing mechanism 12 of the electrical mounting enclosure 1 comprises in this embodiment of the invention a protrusion protruding from the corner of the lid 3 toward the housing wall 22 which has a recess formed by the connecting hole 13 both for receiving a screw connecting the housing to a mounting surface and for receiving the protrusion 12. The protrusion recess -connection is formed as a tight connection so that the lid 3 is secured to the housing 2. Alternatively, the closing mechanism 12 may be provided through a screw connection between the lid 3 and the housing 2.

In the embodiment shown in figure 3 the elongate connecting portion 6 is a cable tie which forms a loop through the primary through hole 4 and the secondary through hole 5 and is closed at its ends such that the loop is adjustable in length but also closed so that the loop does not open by itself. The primary through hole 4 and the secondary through hole 5 are formed by the structures protruding from the side wall 22 facing to the interior space 10. The outlet opening 42 of the primary through hole 4 and the inlet opening 51 of the secondary through hole 5 are facing each other so that the holes are either at least partly overlapping or parallel so that the elongate connecting portion 6 is able through go through both the primary through hole 4 and the secondary through hole 5.

The invention has been described above with reference to the examples shown in the figures. However, the invention is in no way restricted to the above examples but may vary within the scope of the claims.

## Claims

1. An electrical mounting enclosure (1) for surface-mounted electrical installation, the electrical mounting enclosure (1) comprising a housing (2) having a housing bottom (21) and housing walls (22), said housing walls (22) protruding from the housing bottom (21) and forming an opening (23) to the housing (2), and a lid (3) connectable to the housing (2) and arranged to close the opening (23) of the housing (2) for providing a closed electrical mounting enclosure (1) having an interior space (10), **characterized in that** the electrical mounting enclosure (1) comprises
a primary through hole (4) arranged to the housing (2), the primary through hole (4) having an inlet opening (41) and an outlet opening (42) such that the primary through hole (4) extending between the inlet opening (41) and the outlet opening (42); and
a secondary through hole (5) arranged to the lid (3), the secondary through hole (5) having an inlet opening (51) and an outlet opening (52) such that the secondary through hole (5) extending between the inlet opening (51) and the outlet opening (52);
the primary through hole (4) of the housing (2) and the secondary through hole (5) of the lid (3) are adapted to receive a same elongate connecting portion (6) so that the elongate connecting portion (6) passes through the primary through hole (4) and the secondary through hole (5) to connect the housing (2) and the lid (3) to each other through the connecting portion (6).

2. An electrical mounting enclosure (1) according to claim 1, **characterized in that** the primary through hole (4) of the housing (2) and the secondary through hole (5) of the lid (3) are arranged such that the primary through hole (4) and the secondary through hole (5) are parallel in the closed electrical mounting enclosure (1).

3. An electrical mounting enclosure (1) according to claim 1 or 2, **characterized in that** the primary through hole (4) of the housing (2) and the secondary through hole (5) of the lid (3) are arranged such that the through holes are arranged overlapping or at least partially overlapping in a height direction of the closed electrical mounting enclosure (1).

4. An electrical mounting enclosure (1) according to any previous claim, **characterized in that** the primary through hole (4) is formed by a structure (7) arranged in connection with one of the housings walls (22) such that the inlet opening (41) and the outlet opening (42) of the primary through hole (4) open into the interior space (10) formed inside the closed electrical mounting enclosure (1).

5. An electrical mounting enclosure (1) according to any previous claim, **characterized in that** the primary through hole (4) is at least partly formed by one of the housing walls (22).

6. An electrical mounting enclosure (1) according to any previous claim, **characterized in that** the secondary through hole (5) is formed by a structure (8) arranged in connection with the lid (3) such that the inlet opening (51) and the outlet opening (52) of the secondary through hole (5) open into the interior space (10) formed inside the closed electrical mounting enclosure (1).

7. An electrical mounting enclosure (1) according to any previous claim, **characterized in that** the secondary through hole (5) is at least partly formed by the lid (3).

8. An electrical mounting enclosure (1) according to any previous claim, **characterized in that** the electrical mounting enclosure (1) further comprises an elongate connecting portion (6) arranged to connect the housing (2) and the lid (3) together through the primary through hole (4) and the secondary through hole (5),
the elongate connecting portion (6) being arranged in connection with the housing (2) and the lid (3) such that an angle (α) of movement of the lid (3) from an open state of the electrical mounting enclosure (1) to the closed electrical mounting enclosure (1) is at least 180°.

9. An electrical mounting enclosure (1) according to claim 8, **characterized in that** the elongate connecting portion (6) being adjustable in length such that the angle (α) of movement of the lid (3) relative to the housing (2) is changeable.

10. An electrical mounting enclosure (1) according to any previous claim, **characterized in that** the housing bottom (21) facing toward the interior space (10) comprises at least two connectors (9) arranged to connect a mounting rail (91) or a mounting plate to the housing bottom (21).

11. An electrical mounting enclosure (1) according to claim 10, **characterized in that** the connectors (9) are arranged such that the mounting rail (91) extends in a length direction of the housing bottom (21) or in a width direction of the housing bottom (21).

12. An electrical mounting enclosure (1) according to any previous claim, **characterized in that** that the electrical mounting enclosure (1) comprises connecting holes (13) for connecting the electrical mounting enclosure to a mounting surface with screws, which the connecting holes (13) are arranged outside the interior space (10) of the housing (2) such that the connecting holes (13) extend through the housing (2) in a height direction of the housing (2).

13. An electrical mounting enclosure (1) according to any previous claim, **characterized in that** the housing (2) comprises corners and the lid (3) comprises corresponding corners which abut against the corners of the housing (2) in the closed electrical mounting enclosure (1), the corners of the housing (2) and the lid (3) having a closing mechanism (12) for securing the closed electrical mounting enclosure (1).

14. An electrical mounting enclosure (1) according to any previous claim, **characterized in that** the electrical mounting enclosure (1) further comprising a sealing (14) provided between the housing (2) and the lid (3) in the closed electrical mounting enclosure (1) for providing a tight electrical mounting enclosure (1).

15. An electrical mounting enclosure (1) according to claim 14, **characterized in that** the sealing (14) is a separate sealing arranged in connection with the lid (3); or
the sealing is a separate sealing arranged in connection with the housing (2); or
the sealing is part of the lid (3); or
the sealing is part of the housing (2).
